Europäisches Patentamt

European Patent Office

Office européen des brevets

(11) Publication number: **0 341 502**
**A2**

## (12) EUROPEAN PATENT APPLICATION

(21) Application number: 89107643.2

(22) Date of filing: 27.04.89

(51) Int. Cl.⁴: **H01L 39/24** , **H01L 39/22**

(30) Priority: 07.05.88 JP 110888/88
20.01.89 JP 12418/89

(43) Date of publication of application:
15.11.89 Bulletin 89/46

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Morohashi, Shin'ichi Fujitsu Limited
Patent Department 1015 Kamikodanaka
Nakahara-ku Kawasaki-shi Kanagawa 211(JP)

(74) Representative: Sunderland, James Harry et al
HASELTINE LAKE & CO Hazlitt House 28
Southampton Buildings Chancery Lane
London WC2A 1AT(GB)

(54) A cryoelectronic device including a ceramic superconductor.

(57) An integrated circuit device including a ceramic superconductor layer (2; 12; 22) and using a polymerised film (3; 13; 23; 24), having a thickness of approximately 20 nm, formed between the ceramic superconductor layer and an insulating film (4; 25) and/or between the ceramic superconductor layer and the substrate (1; 11; 21), as a buffer layer for protecting the ceramic superconductor layer from humidity in the air around the integrated circuit and from occurrence of solid diffusion (which would otherwise occur due to atoms such as silicon atoms diffusing into the ceramic superconductor layer from the insulating film and/or the substrate); and

a Josephson junction device including a pair of ceramic superconductor layers (32, 34; 32′, 34′) using a polymerised film (33; 33′), having a thickness of approximately 2 nm, formed between the superconductor layers as a barrier layer of the Josephson junction device.

FIG. 3

FIG. 4 (a)

## A cryoelectronic device including a ceramic superconductor

The present invention relates to a cryoelectronic device, for example such as an integrated circuit and/or a Josephson junction device, including a high critical temperature superconductor.

Superconductors made of niobium or lead have been studied with a view to applying them to cryoelectronic devices such as integrated circuits and Josephson junction devices. However, critical temperatures (Tc) of such superconductors are as low as liquid helium temperatures (4.2K), so that, for example, a cryoelectronic device including a Josephson junction would operate only at temperatures as low as 4.2K.

Recently, high Tc superconductors, having Tc's as high as liquid nitrogen temperatures (77K), called "ceramic superconductors", have been discovered. Lanthanum-strontium-copper oxide (LaSrCuO$_x$), yttrium-barium-copper oxide (YBaCuO$_x$) or bismuth-strontium-calcium-copper oxide (BiSrCaCuO$_x$) are typical ceramic superconductors, and some of them have Tc's higher than 77K; for example, the Tc of the BiSrCaCuO$_x$ is higher than 100K. As a result, cryoelectronic devices including such superconductors have begun to be studied seriously with a view to developing practically usable cryoelectronic devices.

A cryoelectronic device including such a ceramic superconductor is made by forming a ceramic superconductor layer on a substrate made of a single crystal such as silicon (Si), strontium-titanium oxide (SrTiO$_3$), aluminium oxide (Al$_2$O$_3$) or magnesium oxide (MgO), by applying an electron beam evaporation method, a sputtering method or a molecular beam epitaxial method. Usually, a YBaCuO$_x$ superconductor is formed on a SrTiO$_3$ substrate and a BiSrCaCuO$_x$ superconductor is formed on an MgO substrate, with a view to minimising lattice mismatching. A silicon oxide film is used as an insulating film, being formed on the ceramic superconductor layer by a thermal oxidation method or a chemical deposition method.

However, in the structure of such a cryoelectronic device, there has been a problem in that a chemical interaction occurs between a silicon element in the silicon oxide film and an alkaline-earth metal element, such as barium, strontium or calcium, in the ceramic superconductor layer, so that these elements diffuse towards each other across the interface between the silicon oxide film and the ceramic superconductor layer. This diffusion of elements affects the interface, resulting in deterioration of the superconductivity of the ceramic superconductor layer.

Furthermore, there has been another problem in that the ceramic superconductor is readily susceptible to deterioration with passage of time due to humidity in the atmosphere. Because of this problem, the life of a cryoelectronic device including the ceramic superconductor is shortened and the fabrication of a cryoelectronic device including the ceramic superconductor is made more difficult.

These problems have been solved by forming an organic plasma polymerised film, which will be simply called a "plasma polymerised film" hereinafter, on to the surface of the ceramic superconductor layer of the cryoelectronic device.

The plasma polymerised film is to passivate the ceramic superconductor, resulting in protection of the ceramic superconductor from humidity, so that the life of the cryoelectronic device is lengthened and difficulty of fabricating the cryoelectronic device is reduced. Details of plasma polymerised films are described in U.S. Patent Application No. 313 767, filed on 22nd February 1989, entitled "A Superconductor Passivated by an Organic Film and a Method for Forming the Organic Film", and in European Patent Application No. 89103217.9. These patent applications will be called "Ref. (1)" and "Ref. (2)" hereinafter, and their disclosures are incorporated in this application by reference.

A ceramic superconductor has a remarkable characteristic in that a coherent length (which is a well-known superconductor characteristic for those skilled in the art) of the ceramic superconductor is very small compared with that of a usual low Tc superconductor. That is, the coherent length of a ceramic superconductor is as small as 1 to 3 nanometers (nm), which is approximately equal to one-tenth of the coherent length of a low Tc superconductor.

In a Josephson junction device, the thickness of an insulating film, which is generally called a "barrier layer" in this case, located between two superconductor layers is required to be smaller than about 3 nm. From the above characteristics of a ceramic superconductor and of a Josephson junction device, it is concluded that flatness of a barrier surface existing between a ceramic superconductor and the barrier layer, and uniformity of the barrier layer, must be better (smaller) than the coherent length of the ceramic superconductor. If the flatness and/or the uniformity is worse than (exceeds) the coherent length of the ceramic superconductor, the Josephson junction device could not possibly have a proper current-voltage characteristic; in other words, the device would lose the Josephson junction function.

When a Josephson junction device uses a low Tc superconductor, the severity of the requirements relating to flatness of the barrier surface between the low Tc superconductor layer and the barrier layer and the uniformity of the barrier layer is less than that of those requirements as they apply to a Josephson junction device using the high Tc ceramic superconductor, because the coherent length of the low Tc superconductor is relatively great. Accordingly, whereas an inorganic barrier layer such as an aluminium oxide ($Al_2O_3$) film could be applied to a Josephson junction device using a low Tc superconductor, it has been found, through many trials, that in the case of the Josephson junction device using a ceramic superconductor it is difficult to apply such inorganic material to the barrier layer, which may be because of the characteristics of the inorganic material. This has been another problem.

Embodiments of the present invention can provide cryoelectronic devices including a ceramic superconductor protected from humidity around the cryoelectronic device and from solid diffusion caused by the elements diffused from an inorganic insulating film formed on the ceramic superconductor and from a substrate on which the ceramic superconductor is formed.

For example, the problem mentioned above involving interaction between silicon in a silicon oxide insulating film and an alkaline-earth metal element in the ceramic superconductor has been found to occur also between a silicon substrate and the ceramic superconductor. Embodiments of the invention can avoid this also.

Embodiments of the present invention can provide cryoelectronic devices, including ceramic superconductors, of long life.

Embodiments of the present invention can provide integrated circuit devices using ceramic superconductor layers formed with inorganic insulating films and/or inorganic substrates without solid diffusion problems arising.

Embodiments of the present invention can provide Josephson junction devices using ceramic superconductor layers with excellent barrier layers free from the problems relating to flatness and uniformity.

In embodiments of the present invention an insulating buffer or barrier layer is made using a plasma polymerised film. In an integrated circuit including a ceramic superconductor layer and an inorganic insulating film, the plasma polymerised film is formed between the ceramic superconductor layer and the inorganic insulating film. In a Josephson junction device including a pair of ceramic superconductor layers, the plasma polymerised film forms an insulating barrier layer between the pair of ceramic superconductor layers.

The plasma polymerised film contains bonds such as a monofluorocarbon (C-F) bond, a difluorocarbon (C-$F_2$) bond and a trifluorocarbon (C-$F_3$) bond of which all three such kinds are or may be present and is formed by applying a conventional plasma discharging method, using an organic gas such as a trifluoromethane gas. Such a plasma discharging method, and properties of plasma polymerised films, are disclosed in Ref. (1) and Ref. (2) described above.

In exemplary embodiments of the present invention, plasma polymerised films are applied as insulating buffer layers, which will be simply called the "buffer layers" hereinafter, to three types of integrated circuits such that:
in a first type, a plasma polymerised film of about 20 nm thickness is formed between the ceramic superconductor layer and an inorganic insulating layer made of a silicon oxide film;
in a second type, a plasma polymerised film of about 20 nm thickness is formed between a silicon substrate and the ceramic superconductor layer; and
in a third type, plasma polymerised films each having approximately 20 nm thickness are formed respectively between a silicon substrate and the ceramic superconductor layer and between the ceramic superconductor layer and an inorganic insulating layer made of the silicon oxide film.

As a result, solid diffusion of silicon, occurring in the silicon oxide and/or the silicon substrate, to the ceramic superconductor layer is prevented by the buffer layer. In other words, the surface of the ceramic superconductor layer does not suffer damage due to silicon solid diffusion.

In further exemplary embodiments of the present invention, plasma polymerised films having thicknesses of at most 3 nm are applied as insulating barrier layers which will be simply called "barrier layers" hereinafter, to Josephson junction devices including pairs of ceramic superconductor layers. Using a plasma polymerised film as a barrier layer, the typical current-voltage characteristic of a Josephson junction can be obtained even though the Josephson junction device uses ceramic superconductor layers.

Also, as described in Ref. (1) and Ref. (2), a plasma polymerised film protects a ceramic superconductor layer from humidity around the ceramic superconductor layer, so that integrated circuit devices and/or Josephson junction devices including ceramic superconductor layers can be fabricated with high reliability. In other words, a cryoelectronic device utilising a ceramic superconductor layer, not previously capable of fabrication as a highly reliable and practical product, can now be provided with polymerised film applied to the cryoelectronic device as buffer layer or barrier layer.

Reference is made, by way of example, to the accompanying drawings, in which:-

Figs. 1 to 5(j) are schematic cross-sectional views relating to exemplary forms of embodiments of the present invention:-

Fig. 1(a) is a schematic cross-sectional view of a sample with a patterned $YBaCuO_x$ layer formed on an $Al_2O_3$ substrate;

Fig. 1(b) is a schematic cross-sectional view of the sample in Fig. 1(a) coated by a plasma polymerised film.

Fig. 1(c) is a schematic cross-sectional view of a basic IC device completed by coating a $SiO_2$ film on the sample illustrated in Fig. 1(b);

Fig. 2(a) is a schematic partial cross-sectional view of a sample with a plasma polymerised film directly formed on a silicon substrate;

Fig. 2(b) is a schematic partial cross-sectional view of a $YBaCuO_x$ layer formed on the sample illustrated in Fig. 2(a);

Fig. 3 is a schematic cross-sectional view of a IC device consisting of a patterned $YBaCuO_x$ layer formed on a silicon substrate through a plasma polymerised film, with a silicon oxide film formed on the patterned $YBaCuO_x$ layer through another plasma polymerised film;

Fig. 4(a) is a schematic partial cross-sectional view of a Josephson junction device;

Fig. 4(b) is a schematic partial cross-sectional view of a Josephson junction device having buffer layers made of a plasma polymerised film;

Fig. 5(a) is a schematic partial cross-sectional view of a sample having a $BiSrCaCuO_x$ layer formed on an MgO substrate;

Fig. 5(b) is a schematic partial cross-sectional view of a patterned plasma polymerised film on the $BiSrCaCuO_x$ layer of Fig. 5(a);

Fig. 5(c) is a schematic partial crosssectional view of a patterned $BiSrCaCuO_x$ layer formed on the MgO substrate of Fig. 5(a);

Fig. 5(d) is a schematic partial crosssectional view of a sample consisting of an MgO substrate, a patterned $BiSrCaCuO_x$ layer, a plasma polymerised film and an $SiO_2$ film;

Fig. 5(e) is a schematic partial crosssectional view of a sample provided by forming a resist pattern on the sample of Fig. 5(d);

Fig. 5(f) is a schematic partial crosssectional view of a sample having a contact hole and a hole for setting a Josephson junction;

Fig. 5(g) is a schematic partial crosssectional view of a sample provided by forming a plasma polymerised film on the sample of Fig. 5(f);

Fig. 5(h) is a schematic partial crosssectional view of a sample provided by forming a ceramic superconductor layer on the sample of Fig. 5(g);

Fig. 5(i) is a schematic partial crosssectional view of a sample provided by forming a patterned resist on the sample of Fig. 5(h); and

Fig. 5(j) is a schematic partial crosssectional view of a IC device having a contact electrode and a counter electrode for Josephson junction;

and

Fig. 6 is a schematic view of a plasma chamber of a plasma generating apparatus.

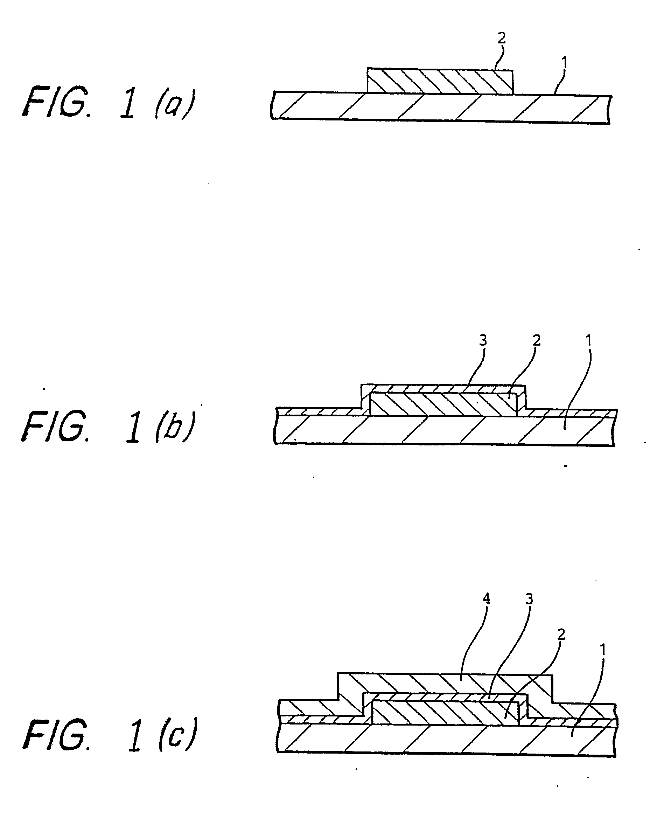

Exemplary forms of five embodiments of the present invention will be described with reference to Figs. 1 to 6. The first, second and third embodiments relate to integrated circuit devices including ceramic superconductor layers, the fourth embodiment relates to Josephson junction devices including pairs of ceramic superconductor layers, and the fifth embodiment relates to devices combining integrated circuit and Josephson junction devices, including a ceramic superconductor layer and a pair of ceramic superconductor layers respectively.

Generally, when a cryoelectronic device including a ceramic superconductor layer is discussed, the following things must be considered:-

(1) The substrate on which the ceramic superconductor layer is to be formed must be selected so that there is satisfactory lattice matching between the ceramic superconductor layer and the substrate;

(2) The occurrence of damage to the ceramic superconductor layer due to the solid diffusion of constituent atoms diffused from a substrate, and/or diffused from an insulating film formed above the surface of the ceramic superconductor layer must be avoided;

(3) The ceramic superconductor layer must be protected from humidity and/or water in the fabrication process for forming the cryoelectronic device; and

(4) The ceramic superconductor layer in the cryoelectronic device must be protected from the humidity in the air around the cryoelectronic device including the ceramic superconductor layer, so as to prolong the product life of the cryoelectronic device.

## FIRST EMBODIMENT

An integrated circuit device, which will be simply called an "IC device" hereinafter, in accordance with the first embodiment of the present invention, is a basic cryoelectronic device including a ceramic superconductor. That is, the structure of the IC device of the first embodiment can be used for fabricating (e.g. incorporated in) further more complex IC devices, for example, an IC device having an electrode which contacts with the ceramic superconductor layer, or other elements stacked over the ceramic superconductor layer. Therefore, an insulating film must be coated over the ceramic superconductor layer. However, some constituent atoms of an inorganic insulating film diffuse into the ceramic superconductor and produce a problem of solid diffusion, which results in degradation of the superconductivity characteristics of the ceramic superconductor layer. For preventing the occurrence of the solid diffusion, a plasma polymerised film is applied so as to be inserted between the ceramic superconductor layer and the inorganic insulating film.

In relation to the first embodiment, Fig. 1(a) shows a partial cross-sectional view of a sample having a patterned ceramic superconductor layer 2, made of $YBaCuO_x$, formed on a substrate 1 made of a single crystal of $Al_2O_3$. The $Al_2O_3$ single crystal substrate is suitable for the formation of the $YBaCuO_x$ layer thereon from the viewpoint of lattice matching. A method of forming and patterning the ceramic superconductor layer on the substrate is disclosed in Ref. (1) and Ref. (2). The $YBaCuO_x$ layer 2 may be formed on the $Al_2O_3$ substrate 1 by a conventional sputtering method, using a mixed gas of argon and oxygen in the volume ratio of 1:1 under a pressure of 2 Pascal (Pa) and applying 3 $W/cm^2$ RF power to electrodes. Under these conditions, the growth rate of $YBaCuO_x$ layer 2 is about 2 nm/min. Then, the $YBaCuO_x$ layer 2 is annealed at a temperature of 900 °C in an oxygen environment for 1 hour. The thickness of the $YBaCuO_x$ layer 2 is controlled so as to obtain a designated value by changing the above conditions appropriately. Instead of a sputtering method, an electron beam (EB) evaporation method, a molecular beam epitaxial (MBE) method or a chemical vapour deposition (CVD) method can be applied. Instead of the $Al_2O_3$, $SrTiO_3$ can be used for the substrate 1. An $LaSrCuO_x$ layer can be used as the ceramic superconductor layer when $SrTiO_3$ is used for the substrate and a $BiSrCuO_x$ layer can be used as the ceramic superconductor layer when MgO is used for the substrate. Combinations of substrate and ceramic superconductor layer directly formed on the substrate are selected in consideration of lattice matching.

After forming the $YBaCuO_x$ layer 2 on the $Al_2O_3$ substrate 1, a plasma polymerised film 3 is formed on the $YBaCuO_x$ layer 2 as a buffer layer; at this time the plasma polymerised film 3 is partly formed also on the $Al_2O_3$ substrate 1. The plasma polymerised film 3 is formed by plasma discharging so as to have 20 nm thickness, using a conventional plasma generating apparatus. A method of forming the plasma polymerised film is described in Ref. (1) and Ref. (2); however, since plasma polymerised films play an important role in embodiments of the present invention, a method will be described briefly below, referring to the illustration of plasma generating apparatus given in Fig. 6.

The plasma generating apparatus has a plasma chamber 101 as shown in Fig. 6. A source gas belonging to a fluoroolefine group or an aromatic fluorohydrocarbon group (or a fluoroalkane group or a fluorohydrocarbon group) is introduced into and exhausted from the plasma chamber 101 through a gas inlet 105 and a gas outlet 106 respectively. After introducing the source gas into the plasma chamber 101 with a pressure of 133 Pa, the plasma is generated in a space between electrodes 102 and 103 of a pair, facing each other in parallel, by applying RF power of 0.1 $W/cm^2$ to the electrodes 102 and 103 from an RF source. The patterned $YBaCuO_x$ layer 2, shown in Fig. 1(a), formed on the $Al_2O_3$ substrate 1, is placed on the electrode 103 as shown by a sample 104 in Fig. 6. Then, the plasma polymerised film 3 of about 20 nm thickness is formed as shown in Fig. 1(b). The thickness of the plasma polymerised film 3 can be varied from 10 to 100 nm by adjusting the pressure of the source gas, a plasma discharging time and the applied RF power.

Besides the disclosed materials in Ref. (1) and Ref. (2), the following materials are useful for the plasma polymerised film:-
polytetrafluoroethylene-tetrafluoroethylene-hexafluoropropylene copolymer,
tetrafluoroethylene-perfluoroalkylvinyl ether copolymer,
tetrafluoroethylene-hexafluoropropylene-perfluoroalkylvinyl ether copolymer,
ethylene-tetrafluoroethylene copolymer,
polychlorotrifluoroethylene-ethylene-chlorotrifluoroethylene copolymer,
polyvinylidene fluoride, and
polyvinyl fluoride.

Fig 1(c) shows a cross-sectional view of the IC device consisting of the $Al_2O_3$ substrate 1, the $YBaCuO_x$ layer 2 formed on the $Al_2O_3$ substrate 1, the polymerised film 3 formed on the $YBaCuO_x$ layer 2 and on a part of the $Al_2O_3$ substrate 1, and an insulating film 4 formed on the polymerised film 3. In Fig. 1(c), the insulating film 4 is made of silicon dioxide ($SiO_2$) and formed on the plasma polymerised film 3 by a conventicnal sputtering method performed in an argon environment with a pressure of 2 Pa, applying RF power of 12 $W/cm^2$. A typical thickness of the $SiO_2$ film is 500 nm: however, it can be varied over the range 200 to 1000 nm.

The reliability of an IC device as shown in Fig. 1(c) was compared with that of an IC device having the same structure as that of Fig. 1(c) except that the buffer layer (3) was excluded, by exposing both IC devices to an environment having 65% RH (relative humidity) at 20°C for 14 days. As a result, the critical temperature of the ceramic superconductor layer 2 in the IC device in Fig. 1(c) was found to be unchanged whilst the critical temperature of the ceramic superconductor layer in the IC device having no buffer layer was drastically reduced, to 4K.

In the first embodiment, silicon nitride ($Si_3N_4$) for instance can be used for the insulating film 4 instead of $SiO_2$. However, $SiO_2$ is most useful in the field of IC devices in view of its simplicity of fabrication and cost.

Since the silicon (Si) atoms in the $SiO_2$ or the $Si_3N_4$ film can cause serious effects, due to solid diffusion, the plasma polymerised film 3 is necessary to prevent the occurrence of the solid diffusion. A sputtering method is mentioned above for forming the $SiO_2$ film 4, but other conventional methods, such as an evaporation method, can be applied.

SECOND EMBODIMENT

In the first embodiment, the substrate 1 made of $Al_2O_3$ is suitable for directly mounting the ceramic superconductor ($YBaCuO_x$) layer 2 thereon. In the context of IC devices however, a single crystal of silicon (Si) is more useful than $Al_2O_3$. However, when an Si substrate is used, solid diffusion is created in the $YBaCuO_x$ layer 2 by the Si atoms diffused from the Si substrate. To avoid the occurrence of the solid diffusion, a plasma polymerised film is inserted between the Si substrate and the ceramic superconductor layer. The second embodiment of the present invention concerns the use of an Si substrate.

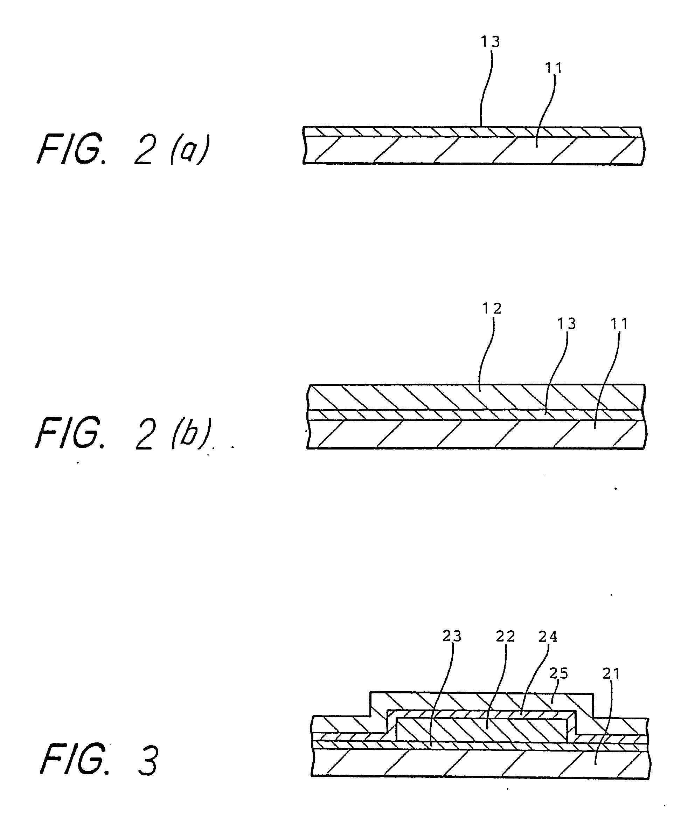

In the second embodiment, a plasma polymerised film is used as a buffer layer formed between the ceramic superconductor layer and an Si substrate. As shown in Fig. 2(a), a plasma polymerised film 13 is formed, as a buffer layer, on a substrate 11 made of an Si single crystal. The plasma polymerised film 13 is fabricated in the same way as in the first embodiment, so as to have about 20 nm thickness. Fig. 2(b) shows a cross-sectional view of a ceramic superconductor ($YBaCuO_x$) layer 12 formed on the plasma polymerised film 13 formed on the Si substrate 11. The way of forming the $YBaCuO_x$ layer 12 is the same as in the first embodiment. Solid diffusion in the $YBaCuO_x$ layer 12 due to Si atoms from the Si substrate 11 is avoided by the provision of the buffer layer of the plasma polymerised film 13. In the second embodiment, of course, a single crystal substrate of, for example, $SrTiO_3$ or $Al_2O_3$ can be used instead of single crystal of Si, and $LaSrCuO_x$ or $BiSrCaCuO_x$ can be used as the material of the ceramic superconductor layer instead of $YBaCuO_x$, for example.

THIRD EMBODIMENT

An IC device in accordance with a third embodiment of the present invention is a device combining features of the IC devices of the first and second embodiments of the present invention. The IC device of the third embodiment is shown in a schematic cross-sectional view in Fig. 3. In Fig. 3, a patterned $YBaCuO_x$ layer 22 is formed on a buffer layer 23 formed on an Si substrate 21 and another buffer layer 24 is formed on the patterned $YBaCuO_x$ layer 22, and partly on the buffer layer 23, and an inorganic film 25 made of $SiO_2$ is formed on the buffer layer 24. The patterned $YBaCuO_x$ layer 22 is fabricated in the same way as in the first embodiment. The buffer layers 23 and 24 and the $SiO_2$ insulating film 25 are fabricated respectively also in the same way as in the first embodiment. In the third embodiment, a single crystal substrate of $SrTiO_3$ or $Al_2O_3$ can be used as substrate instead of Si, and $LaSrCuO_x$ or $BiSrCaCuO_x$ can be used as the material of the ceramic superconductor layer instead of $YBaCuO_x$, for example.

In the first, second and third embodiments, the thickness of the or each plasma polymerised films used as buffer layers is typically about 20 nm, although it can be varied, for example over the range 10 nm to 100 nm. The plasma polymerised film protects the ceramic superconductor layer from damage due to solid diffusion. At the same time, the plasma polymerised film protects the ceramic superconductor layer from humidity in the air. As a result, in the first to third embodiments, the ceramic superconductor layer in the IC device can maintain high-quality superconductivity properties, which results in prolonged life for the IC device.

FOURTH EMBODIMENT

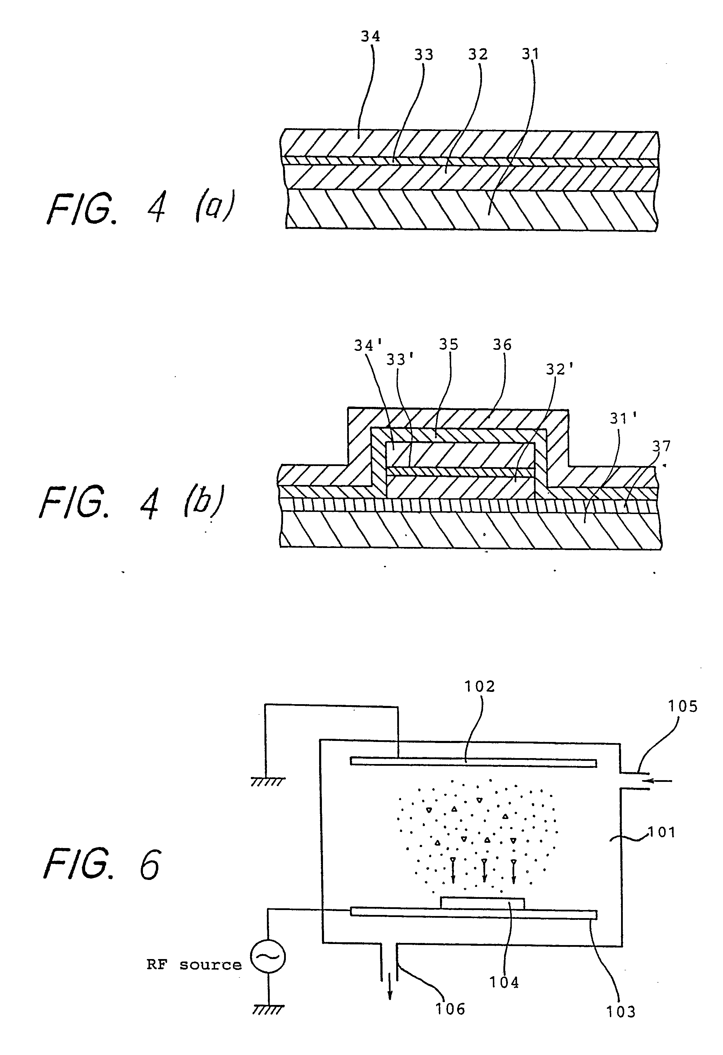

The plasma polymerised film can also be used as a barrier layer in a Josephson junction device, which will be described below, with reference to Figs. 4(a) and 4(b), as a fourth embodiment of the present invention.

Fig. 4(a) shows a schematic partial cross-sectional view of a Josephson junction device including a pair of ceramic superconductor layers 32 and 34. A ceramic superconductor layer 32 made of $YBaCuO_x$, $LaSrCuO_x$ or $BiSrCaCuO_x$ is formed on a substrate 31 made of a single crystal of, for example, $SrTiO_3$, $Al_2O_3$ or MgO. As the barrier layer, plasma polymerised film 33 is formed on the ceramic superconductor layer 32 so as to be 0.5 nm to 3 nm in thickness, by the same method as described in relation to the first embodiment.

A plasma polymerised film has a remarkable characteristic in that it can be fabricated very thinly and with excellent uniformity. Because of this characteristic, it can be said that the plasma polymerised film is well fitted for use as the barrier layer of the Josephson junction device.

The barrier layer 33 is fabricated, having a thickness of 2 nm for example, and having good uniformity. This value of 2 nm is equal to approximately one-tenth of the thickness of the buffer layer in the IC devices of the first to third embodiments of the present invention. After forming the barrier layer 33, another ceramic superconductor layer 34 is formed on the barrier layer 33, as a counter electrode. The Josephson junction device fabricated in this way has a current-voltage characteristic typical of a Josephson junction.

Fig. 4(b) shows another form of Josephson junction device in accordance with the fourth embodiment, having buffer layers each made of the plasma polymerised film. In Fig. 4(b), a Josephson junction part is constructed of two ceramic superconductor layers $32'$ and $34'$ with a barrier layer $33'$ between them. The Josephson junction part is formed on a substrate $31'$ through a first buffer layer 37 made of plasma polymerised film, and the upper surface of the Josephson junction part is insulated by coating an inorganic film 36 on to the Josephson junction part through a second buffer layer 35 made of plasma polymerized film. In relation to Fig. 4(b), for the fourth embodiment, Si, $SrTiO_3$, $Al_2O_3$ or MgO can be used for the substrate, $YBaCuO_x$, $LaSrCuO_x$ or $BiSrCaCuO_x$ can be used for the ceramic superconductor layer and $SiO_2$ or $Si_3N_4$ can be used for the inorganic film, for example. The thickness of the plasma polymerised films 35 and 37 is typically about 20 nm, although it can be varied over the range 10 nm to 100 nm. The thickness of the barrier layer $33'$ is typically 2 nm, although it can be varied over the range 0.5 nm to 3 nm. The Josephson junction device fabricated in this way has a typical Josephson device current-voltage characteristic and high product reliability.

FIFTH EMBODIMENT

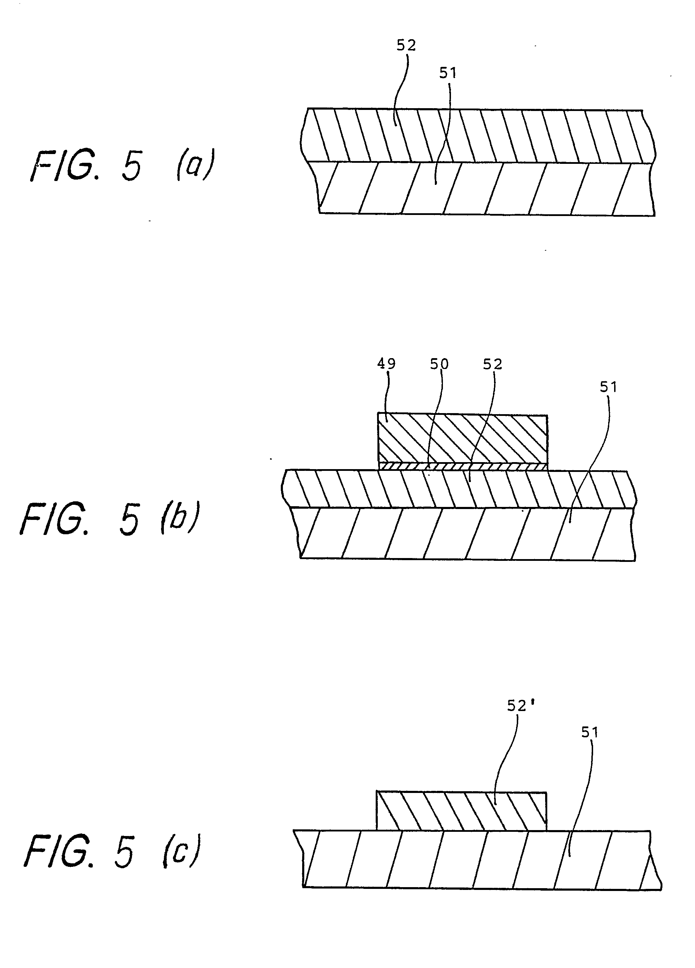

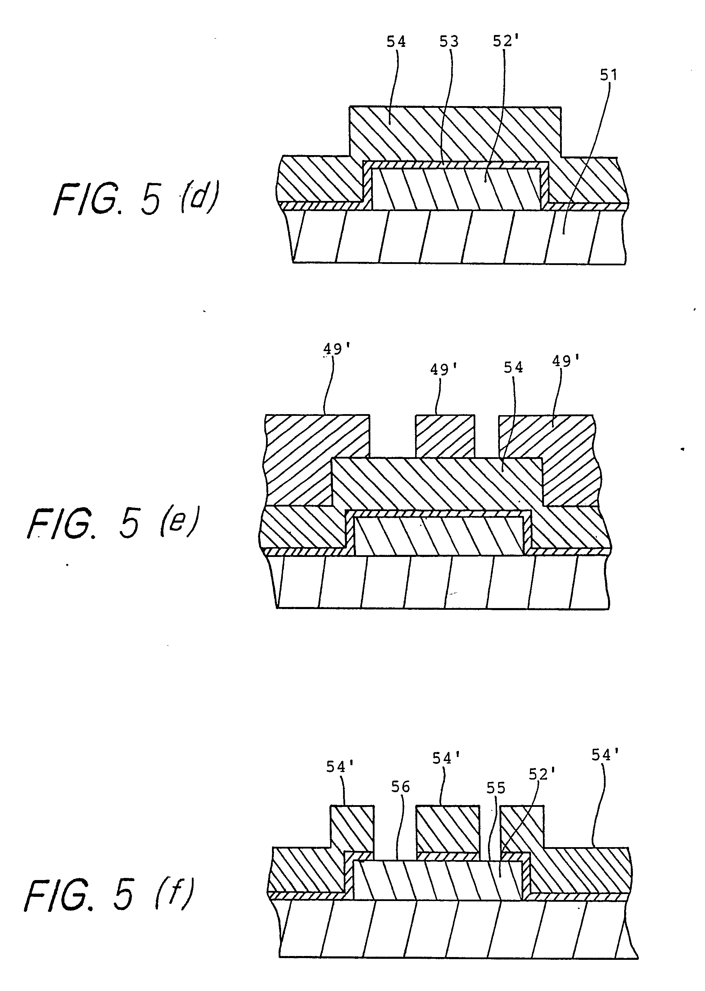

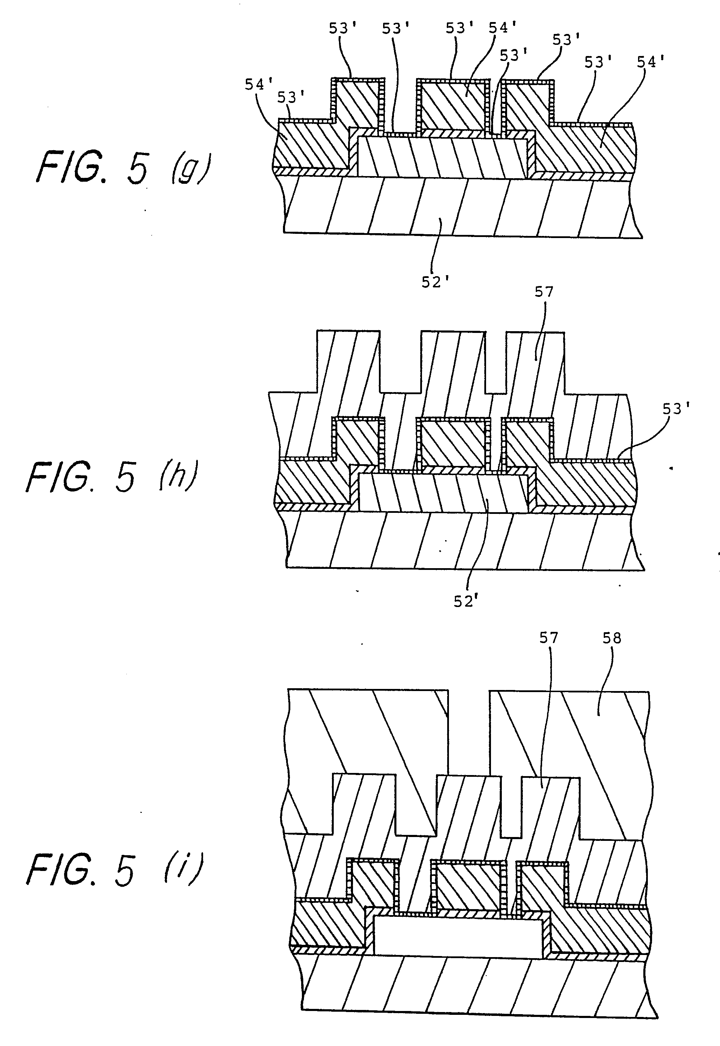

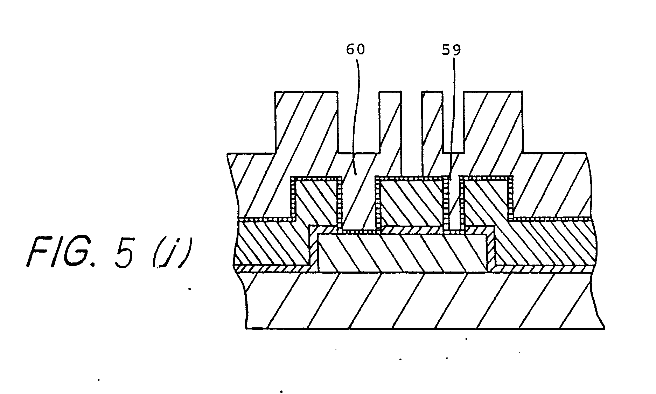

Combining the IC device and the Josephson junction device described respectively in relation to the first embodiment and the fourth embodiment, an IC device including a Josephson junction device will be described as a fifth embodiment of the present invention, illustrating a fabrication process for the IC device including the Josephson junction device with reference to Figs. 5(a) to 5(j).

Fig. 5(a) shows a schematic partial cross-sectional view of a ceramic superconductor layer 52 formed on a substrate 51. For example, the substrate 51 is made of an MgO crystal and the ceramic superconductor layer 52 is made of $BiSrCaCuO_x$ having a thickness of 200 nm.

A plasma polymerised film is formed on substantially the entire surface of the $BiSrCaCuO_x$ layer 52 and patterned using a resist 49 formed thereon, producing a patterned plasma polymerised film 50 as shown in the schematic cross-sectional view in Fig. 5(b).

The $BiSrCaCuO_x$ layer 52 in Fig. 5(b) is pattern-etched by a reactive ion etching method, using the resist 49 as a mask, producing a patterned $BiSrCaCuO_x$ layer $52'$ as shown by the schematic cross-sectional view of Fig. 5(c).

In the above process steps the film 50 serves to protect the ceramic superconductor of layer 52 from water and acid (such as developer) used during resist (49) patterning, for patterning the layer 52.

A plasma polymerised film 53 of about 15 nm thickness is formed on the patterned $BiSrCaCuO_x$ layer $52'$ of Fig. 5(c), and an $SiO_2$ film 54 in about 350 nm thickness is formed on the plasma polymerised film 53 by a conventional RF sputtering method, applying 10 $W/cm^2$ of power and using argon gas under a pressure of 1 Pa. The result is shown in the schematic cross-sectional view of Fig. 5(d).

In order to determine areas for a Josephson junction and a contact hole for the Josephson junction, resist-patterning is performed on the $SiO_2$ film 54 in Fig. 5(d) by a conventional lithography method, using a patterned resist $49'$ provided on the $SiO_2$ film 54 as shown in the schematic cross-sectional view of Fig. 5(e).

Then, the $SiO_2$ film 54 is pattern-etched by reactive ion etching (RIE) technique, using a tetrafluoromethane gas mixed with 5% oxygen in volume under a pressure of 7 Pa, applying RF power of 0.1 $W/cm^2$, producing a patterned $SiO_2$ film $54'$. After that, the plasma polymerised film 53 is pattern-etched by applying oxygen ashing technique, using the patterned $SiO_2$ film as a mask, under a pressure of 30 Pa and RF power of 0.2 $W/cm^2$. After removing the resist $49'$, a hole 56 having a diameter of 10 $\mu$m for making contact with the patterned $BiSrCaCuO_x$ layer $52'$ and a hole 55 having a diameter of 2 $\mu$m for making a Josephson junction are provided in the $SiO_2$ film 54 so that these holes extend to the surface of the patterned $BiSrCaCuO_x$ layer $52'$, as shown by the schematic cross-sectional view of Fig. 5(f).

Then, a plasma polymerised film $53'$ is formed

on the patterned BiSrCaCuO$_x$ layer 52' appearing at the bottoms of the two holes 55 and 56 and on the patterned SiO$_2$ film 54' as shown by the schematic cross-sectional view of Fig. 5(g). The plasma polymerised film 53' is formed by using a CHF$_3$ gas having a pressure of 133 Pa and RF power of 0.05 W/cm$^2$. The thickness of the plasma polymerised film 53' is controlled so as to be in the range 0.5 to 3 nm. As mentioned above, the plasma polymerised film 53' is formed on the SiO$_2$ film 54', but the plasma polymerised film 53' on the SiO$_2$ film 54' can be functionally neglected because the thickness of the plasma polymerised film 53' is less than 1% of the thickness of the SiO$_2$ film 54'.

Then, a ceramic superconductor layer 57 is formed as a counter electrode, with a thickness in the range 500 to 600 nm, on the plasma polymerised film 53' as shown in the schematic cross-sectional view of Fig. 5(h). The formation of the ceramic superconductor layer 57 is performed by the same method as is used for forming the ceramic superconductor layer 52 in the step shown in Fig. 5(a).

Then, a resist 58 is formed on the ceramic superconductor layer 57 via a plasma polymerised film which is not depicted, as illustrated by the schematic cross-sectional view of Fig. 5(i). The resist 58 is patterned so as to be separated to two blocks for fabricating a counter electrode 59 for the Josephson junction and a contact electrode 60 to the patterned BiSrCaCuO$_x$ layer 52' by conventional lithography, as shown in Fig. 5(i).

Finally, the ceramic superconductor layer 57 shown in Fig. 5(h) is separated into two blocks by the RIE method, using the resist 58 as a mask. After removing the resist 58, the counter electrode 59 and the contact electrode 60 are fabricated as shown in the schematic cross-sectional view of Fig. 5(j).

When the area of a Josephson junction becomes large, a large critical current flows through the Josephson junction. Therefore, the critical current can be controlled by changing the area of the Josephson junction. The contact 60 is simply for making the critical current flow through the patterned BiSrCaCuO$_x$ layer 52' and the Josephson junction.

Embodiments of the present invention provide:- an integrated circuit device including a ceramic superconductor layer and using a polymerised film, having a thickness of approximately 20 nm, formed between the ceramic superconductor layer and an insulating film and/or between the ceramic superconductor layer and the substrate, as a buffer layer for protecting the ceramic superconductor layer from humidity in the air around the integrated circuit and from occurrence of solid diffusion (which would otherwise occur due to atoms such as silicon atoms diffusing into the ceramic superconductor layer from the insulating film and/or the substrate); and

a Josephson junction device including a pair of ceramic superconductor layers using a polymerised film, having a thickness of approximately 2 nm, formed between the superconductor layers as a barrier layer of the Josephson junction device.

## Claims

1. An integrated circuit device comprising:-
a substrate;
a ceramic superconductor layer formed on said substrate;
a plasma polymerised film formed on said ceramic superconductor layer; and
an inorganic insulating film formed on said plasma polymerised film.

2. An integrated circuit device comprising:-a substrate;
a plasma polymerised film formed on said substrate; and
a ceramic superconductor layer formed on said first plasma polymerised film.

3. An integrated circuit device according to claim 2, further comprising:-
a further plasma polymerised film formed on said ceramic superconductor layer; and
an inorganic-insulating film formed on said further plasma polymerised film.

4. An integrated circuit device according to claim 1, wherein said substrate is a single crystal substrate of a material selected from the group consisting of strontium-titanium oxide (SrTiO$_3$), aluminium oxide (Al$_2$O$_3$) and magnesium oxide (MgO).

5. An integrated circuit device according to claim 2 or 3, wherein said substrate is a single crystal substrate of a material selected from the group consisting of silicon (Si), strontium-titanium oxide (SrTiO$_3$), aluminium oxide (Al$_2$O$_3$) and magnesium oxide (MgO).

6. An integrated circuit device according to claim 1, 2, 3 or 4, wherein said ceramic superconductor layer is made of a material selected from the group consisting of yttrium-barium-copper oxide (YBaCuO$_x$), lanthanum-strontium-copper oxide (LaSrCuO$_x$) and bismuth-strontium-calcium-copper oxide (BiSrCaCuO$_x$).

7. An integrated circuit device according to any preceding claim, wherein the or each said plasma polymerised film is fabricated by plasma discharging performed in a source gas selected from gases belonging to a fluoroolefin group or a fluoroalkane group or a fluorohydrocarbon group or an aromatic fluorohydrocarbon group, so as to provide the film with a thickness in the range 10 nm to 100 nm.

8. An integrated circuit device according to any preceding claim, wherein said inorganic insulating film is made of a material selected from the group consisting of silicon dioxide $(SiO_2)$ and silicon nitride $(Si_3N_4)$.

9. A Josephson junction device comprising:-
a substrate;
a first ceramic superconductor layer formed on said substrate;
a first plasma polymerised film formed on said first ceramic superconductor layer; and
a second ceramic superconductor layer formed on said first plasma polymerised film.

10. A Josephson junction device according to claim 9, comprising another plasma polymerised film formed between said substrate and said first ceramic superconductor layer.

11. A Josephson junction device according to claim 9 or 10, comprising a further plasma polymerised film formed on said second ceramic superconductor layer, and an inorganic insulating film formed on said further plasma polymerised film.

12. A Josephson junction device according to claim 9 or claim 11 when read as appended to claim 9, wherein said substrate is a single crystal substrate of a material selected from the group consisting of strontium-titanium oxide $(SrTiO_3)$, aluminium oxide $(Al_2O_3)$ and magnesium oxide $(MgO)$.

13. A Josephson junction device according to claim 10 or claim 11 when read as appended to claim 10, wherein said substrate is a single crystal substrate of a material selected from the group consisting of silicon (Si), strontium-titanium oxide $(SrTiO_3)$, aluminium oxide $(Al_2O_3)$ and magnesium oxide $(MgO)$.

14. A Josephson junction device according to any of claims 9 to 13, wherein said first ceramic superconductor layer and said second ceramic superconductor layer are respectively made of materials selected from the group consisting of yttrium-barium-copper oxide $(YBaCuO_x)$, lanthanum-strontium-copper oxide $(LaSrCuO_x)$ and bismuth-strontium-calcium-copper oxide $(BiSrCaCuO_x)$.

15. A Josephson junction device according to any of claims 9 to 14, wherein said first plasma polymerised film is fabricated by plasma discharging performed in a source gas selected from gases belonging to a fluoroolefine group or a fluoroalkane group or a fluorohydrocarbon group or an aromatic fluorohydrocarbon group, so as to have a thickness from 0.5 nm to 3 nm.

16. A Josephson junction device according to claim 10 or 11, or any of claims 12 to 15 read as appended to claim 10 or 11, wherein the or each plasma polymerised film other than the first is fabricated by plasma discharging performed in a source gas selected from gases belonging to a fluoroolefin group or a fluoroalkane group or a fluorohydrocarbon group or an aromatic fluorohydrocarbon group, so as to have a thickness from 10 nm to 100 nm.

17. A Josephson junction device according to any of claims 9 to 16, said inorganic insulating film being made of a material selected from the group consisting of silicon dioxide $(SiO_2)$ and silicon nitride $(Si_3N_4)$.

FIG. 1 (a)

FIG. 1 (b)

FIG. 1 (c)

FIG. 2 (a)

FIG. 2 (b)

FIG. 3

FIG. 4 (a)

FIG. 4 (b)

FIG. 6

FIG. 5 (a)

FIG. 5 (b)

FIG. 5 (c)

*FIG. 5 (d)*

54 53 52' 51

*FIG. 5 (e)*

49' 49' 54 49'

*FIG. 5 (f)*

54' 54' 54'
56 55 52'

FIG. 5 (g)

FIG. 5 (h)

FIG. 5 (i)

FIG. 5 (j)